# EUROPEAN PATENT APPLICATION

(11) **EP 1 246 273 A2**
(43) Date of publication of application: **02.10.2002**
(21) Application number: 02252245.2
(22) Date of filing: 27.03.2002
(51) Int. Cl.: H01L 51/20, H01L 51/40

(54) **Electroluminescence display and manufacturing method of same, mask and manufacturing method of same**

(30) Priority: 27.03.2001 JP 2001090165
(71) Applicant: Sanyo Electric Co., Ltd., Moriguchi-shi, Osaka (JP)
(72) Inventor: Yamada, Tsutomu, Motosu-Gun, Gifu (JP); Nishikawa, Ryuji, Gifu-shi, Gifu (JP)
(74) Representative: Cross, Rupert Edward Blount

(57) **Abstract**

In an EL display having an EL element in which an emissive element layer is formed between an anode and a cathode, projections (pillars) (20) are formed on a base structure (10) in a region outside the emissive region, so that a hole transport layer, an emissive layer, and an electron transport layer can be formed through evaporation while the distance from the mask is maintained. Alternatively, the pillars (20) can be formed on the mask.

## Description

### BACKGROUND OF THE INVENTION

### 1. Field of the Invention

The present invention relates to an electroluminescence (hereinafter referred to as "EL") display manufactured by depositing a material for an emissive layer on an EL element and to a method for manufacturing such an EL display, as well as to a mask used for the deposition process and a method for manufacturing such mask.

### 2. Description of the Related Art

In recent years, EL displays employing EL elements have attracted much attention as alternatives to CRT (cathode ray tube) and LCD (liquid crystal display) devices. EL displays which use thin film transistors (hereinafter, referred to as "TFTs") as switching elements for driving the EL elements are currently being developed.

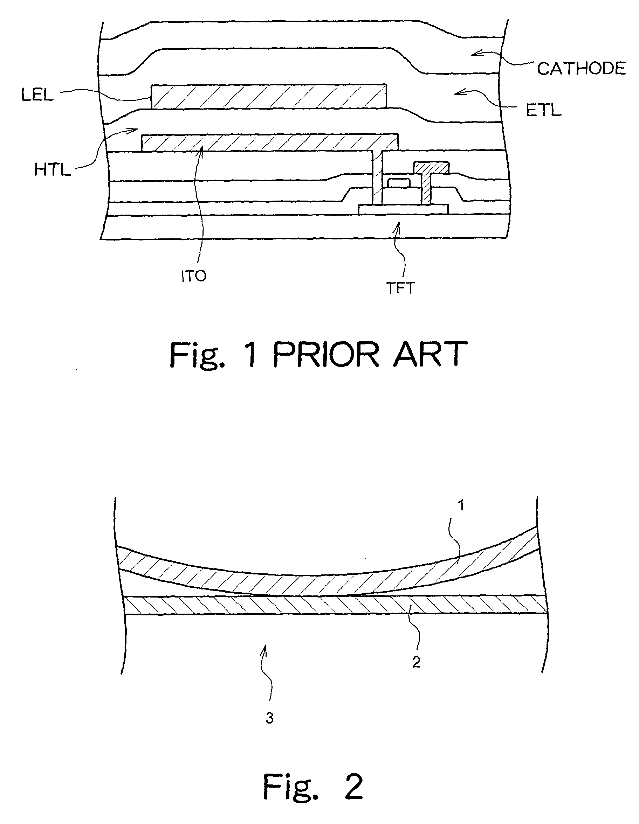

Fig. 1 is a cross sectional view of the area near one pixel of a conventional EL display device. As shown in Fig. 1, near a pixel of an EL display employing a TFT, on a base structure comprising a TFT and an anode (ITO) on the surface, for example, a hole transport layer (HTL), an emissive layer (light emitting layer, or LEL), and an electron transport layer (ETL) are laminated in that order as an emissive element layer, and a cathode is formed on the emissive element layer. The emissive layer has been conventionally formed through the following process.

To form an emissive layer in a desired region on a base structure 1 with ITO completely formed, a mask 2 having an opening corresponding to the desired region is placed in contact with the base structure 1. Then, the mask 2 is aligned with the base structure 1 so that an emissive layer can be formed at the desired region. Next, an emissive material is deposited from an emissive material source, which is the deposition material source, through the opening of the mask 2 by evaporation. Because this process is performed in a vacuum chamber, no means for fixing the base structure, such as, for example, attachment fixture onto a support or the like is available. As a result, flexure of the base structure and a local section 3 of the mask that touches the base structure 1 (Fig. 2) is generated.

The local contact (3) between the mask used for forming the emissive layer and the base structure may damage the TFT and hole transport layer HTL which are already formed and may create a spot called a "dark spot", and thus, is not desirable.

### SUMMARY OF THE INVENTION

The present invention was conceived to solve at least the problem described above, and one object of the present invention is to provide an EL display, a manufacturing method of the EL display, a mask, and a manufacturing method of the mask, in which damage to the TFTs, hole transport layer, or the like, and the generation of dark spots due to local contact are all reduced.

In order to achieve at least the object mentioned above, according to the present invention, there is provided an electroluminescence display comprising an emissive element layer in turn comprising an emissive layer and formed between a first electrode and a second electrode by placing, in contact with a base structure onto which the first electrode is formed, a mask having an opening for allowing an emissive material to be deposited onto a desired emissive region, and depositing emissive material from an emissive material source through the opening, wherein, at least one of the base structure and the mask comprises projections for maintaining a predetermined distance between the base structure and the mask, and projections being in contact with the non-emissive regions of the base structure.

Also in order to solve at least the problem mentioned above, according to the present invention, there is further provided a method for manufacturing an electroluminescence display wherein, when an emissive layer is formed between a first electrode and a second electrode by placing, in contact with a base structure onto which the first electrode is formed, a mask having an opening for allowing an emissive material to be deposited onto a desired emissive region, and depositing the emissive material from an emissive material source through the opening, projections for maintaining a predetermined distance between the base structure and the mask are provided on the non-emissive region on the base structure, and the emissive material is deposited onto the desired emissive region on the base structure while the distance between the base structure and the mask is maintained.

According to another aspect of the present invention, it is preferable that the projections are provided corresponding to each pixel. According to another aspect of the present invention, it is preferable that the projections are provided between pixels. According to yet another aspect of the present invention, it is preferable that the projections are provided between the display panels when a plurality of display panels are formed on the base structure in gang printing.

In order to solve at least the problem mentioned above, according to the present invention, there is also provided an electroluminescence display which is manufactured by any one of the methods for manufacturing an electroluminescence display described above.

According to the present invention, there is still further provided a method for manufacturing a mask for placement between an emissive material source and a base structure as the deposition target of the emissive material and having an opening for allowing the emissive material to be deposited onto a desired emissive region on the base structure, wherein projections are employed for maintaining a predetermined distance from the base structure.

According to a yet further aspect of the present invention, there is provided a mask for placement between an emissive material source and a base structure as the deposition target of the emissive material, the mask having an opening for allowing the emissive material to be deposited onto a desired emissive region on the base structure, and the mask further comprising projections for maintaining a predetermined distance from the base structure.

According to the present invention, when an emissive element layer of an EL display is formed by placing in contact with a base structure onto which a first electrode is formed a mask having an opening for allowing an emissive material to be deposited onto a desired emissive region, and depositing an emissive material from an emissive material source through the opening, at least one of the base structure and the mask comprises projections for maintaining a predetermined distance between the base structure and the mask. Therefore, local contact of the mask with the emissive region on the base structure can be prevented, and the possibility of damage to the TFT, hole transport layer, or the like forming the emissive element layer can be reduced, as can the probability of generation of dark spots.

### BRIEF DESCRIPTION OF THE DRAWINGS

Fig. 1 is a cross sectional view of a conventional EL display.
Fig. 2 is a diagram for explaining the relationship between a base structure and a mask of a conventional EL display.
Figs. 3A, 3B, 3C, and 3D are diagrams for explaining manufacturing steps of an EL display according to a first embodiment of the present invention.
Fig. 3E is a diagram showing a possible shape for projections according to the present invention.
Fig. 4 is an explanatory diagram showing an example of the placement position of projections when the projections are provided for each pixel.
Fig. 5 is an explanatory diagram showing an example of the placement position of projections when the projections are provided for each predetermined number of pixels.
Fig. 6 is an explanatory diagram showing an example of placement position of projections in gang printing.
Fig. 7 is an explanatory diagram showing the manufacturing process of an EL display using the mask according to a second embodiment of the present invention.

### DESCRIPTION OF PREFERRED EMBODIMENTS

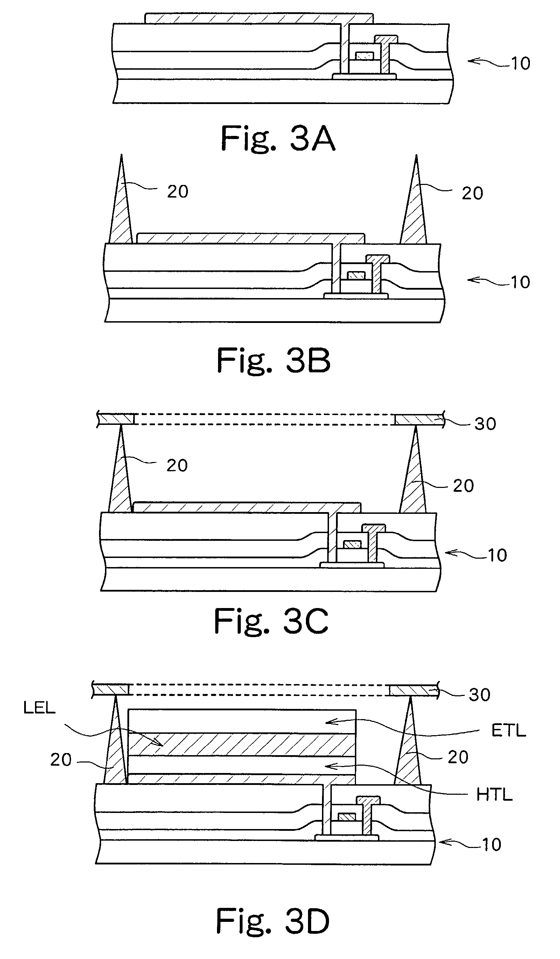

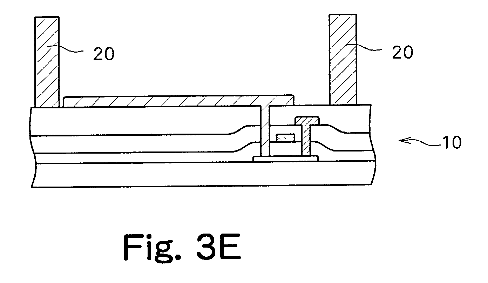

A first preferred embodiment of the present invention will now be described referring to the drawings. In a method for manufacturing an EL display according to the first embodiment, as shown in Fig. 3B, projections 20 are formed using, for example, a photoresist on a planarization insulative layer formed above a glass substrate 10 which is the base structure onto which TFT and ITO are formed (Fig. 3A), in positions outside the emissive region. The emissive region corresponds to the region where ITO is formed. The projections 20 are formed with a height of approximately 2 µm ∼ 10 µm. By forming the projections using a photoresist as described above, the projections can be precisely and reliably formed with a height of 2 ∼ 10 µm, for example, about 4 µm. Projections with the height of about 4 µm can be very easily formed using a resist. However, the height of the projections 20 is not limited to the range of 2 ∼ 10 µm, and with a height of, for example, about ten times the total thickness of the anode and the emissive element layer, it is possible for the projections 20 to prevent contact between the base structure surface and the mask, even when flexure of the glass substrate occurs and local contact between the glass substrate and the mask would occur without the presence of the projections. In consideration of subsequent steps for cleaning, drying, etc., and to reduce the possibility of poor washing, liquid residues, or the like, it is further preferable that the projections 20 have a tapered shape such as a cone, a pyramid, or the like, with a triangular, rectangular, or other suitable base shape . The shape of the projections 20 is not limited, however, to such tapered shapes, and pillars or columns as shown in Fig. 3E having various cross sectional shapes including circular and polygonal may also be employed as the projections.

With such a structure, even when the mask 30 is placed in proximity to the glass substrate 10 in a vacuum chamber for evaporation and when flexure in the glass substrate 10 occurs, only the mask 30 and the projections 20 formed on the glass substrate 10 are contacted (Fig. 3C), and the glass substrate 10 does not touch the mask 30.

As described above, the mask 30 is moved in order to align the opening of the mask 30 with the desired emissive region on the glass substrate 10. When this is done, because the mask 30 and the projections 20 are at least locally contacted, the mask 30 is not easily moved by sliding and, thus, it is possible to suitably align the opening of the mask.

After the opening of the mask has been suitably aligned, a gap of a predetermined distance is maintained by the projections 20 while deposition materials are sequentially evaporated from deposition material sources (not shown) through the opening of the mask 30 so that a hole transport layer HTL, an emissive layer LEL, and an electron transport layer ETL are sequentially evaporated and laminated (Fig. 3D). Then, a cathode common to the pixels is evaporated. The projections 20 can be removed, such as by being cut off, or can be sealed into the structure. One or both of the hole transport layer HTL and the electron transport layer ETL may be formed common to all pixels. When this is done, the mask 30 as shown becomes unnecessary for formation of the hole transport layer HTL and/or the electron transport layer ETL. On the other hand, when unique patterns are desired for each pixel, similar as with the emissive layer, evaporation is performed with the mask 30 as shown.

Preferable placement of the projections 20 will now be described. The projections 20 can be provided for each pixel, for each predetermined number of pixels, or between display panels in a case of a structure comprising a plurality of display panels, so-called "gang printing".

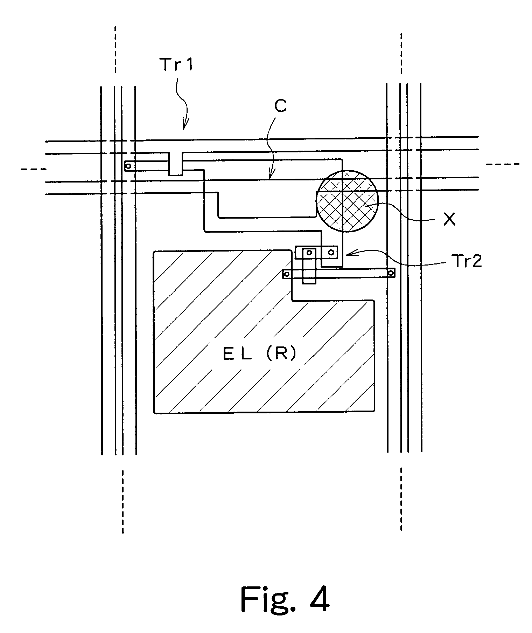

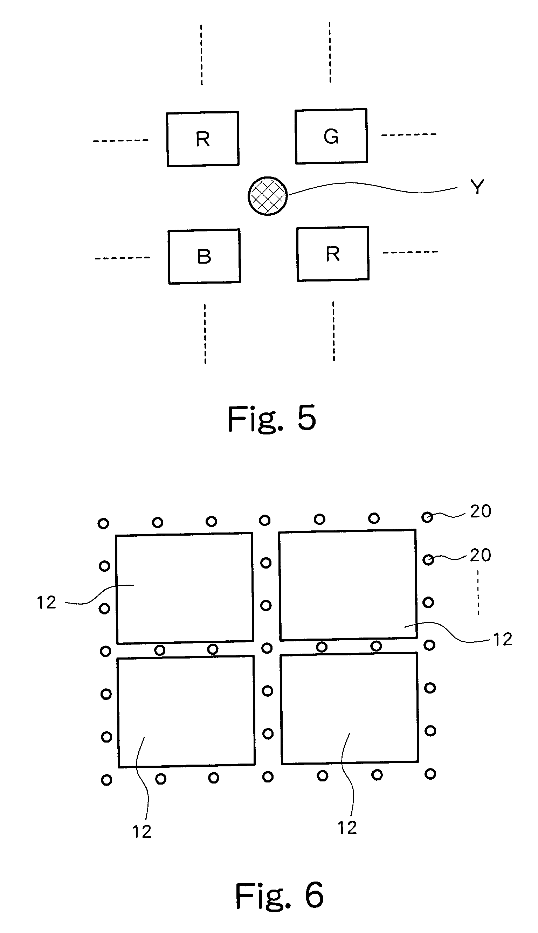

First, an example wherein the projections 20 are provided for each pixel will be described. Fig. 4 is a plane view of the EL display on the side of the base structure near a display pixel. An example of preferable placement of the projections 20 in a case where the projections 20 are provided for each pixel will now be described referring to Fig. 4. As shown in Fig. 4, a display pixel comprises a first transistor Tr1, a storage capacitor C, a second transistor Tr2, and an EL element for emitting light of a desired color such as, for example, R, G, and B (shown as emissive region R in the figure) . When the projections 20 are provided for each pixel, the projections 20 are formed at positions as far away from the emissive region as possible, for example, near the storage capacitor (for example, region X in Fig. 4). In other words, the projections 20 are provided outside the emissive region R. In a case where the projections 20 are provided for each predetermined number of pixels, the projections 20 can be formed at the position shown in Fig. 4, but for every predetermined number of pixels rather than for all pixels. Also, when there is a sufficient space, for example, above the wiring between the pixels (region Y in Fig. 5, etc.), the projections 20 may be formed on the wiring as a spot as shown in Fig. 5. The projections 20 may also be formed on the wiring as a strip along the wiring, which may in some cases be discontinuous. As described above, the projections 20 may have a tapered shape or may have a wall-like structure without a taper.

Further, in gang printing, as shown in Fig. 6, the projections 20 can be placed between display panels 12 each comprising a plurality of pixels to surround the display panels 12.

According to the method of manufacturing an EL display of the first embodiment, local contact between the layers already formed on the glass substrate 10 (such as a TFT, an anode, and a predetermined organic layer) and the mask 30 can be prevented, and, thus, the possibility of damage to the TFT, hole transport layer, or the like, and the probability of dark spot generation, can be reduced.

In order to provide a gap of a predetermined distance between the substrate and the mask, the projections may be formed on the mask rather than on the substrate. A second embodiment of the present invention will now be described in which projections are formed on the mask.

In the second embodiment, projections 31 are formed on the mask 30 on which an opening is provided for allowing a deposition material to be deposited onto a desired region. The projections 31 of the mask 30 may be formed in separate steps by an organic material such as, for example, a resist, after the mask 30 is manufactured, or, alternatively, may be integrally formed when the mask 30 is manufactured. The projections 31 are formed with a height of 2 ∼ 10 µm corresponding to the flexure of the glass substrate. It is preferable that the projections 31 have a tapered shape such as a cone in consideration of the subsequent steps such as cleaning, but the shape of the projections 31 on the mask is not limited to a tapered structure, and pillars or columns as shown in Fig. 3E or wall-like structured projections which do not have a tapered structure may also be employed.

The projections 31 are formed on the mask 30 at positions which contact the non-emissive region on the glass substrate 10 when the opening of the mask 30 is aligned with the desired emissive region on the glass substrate 10. In other words, the formation positions of the projections 31 on the mask 30 depends on the target glass substrate 10 . It is preferable that the contact positions be aligned so that the positions coincide with those shown in Figs. 4 through 6 and described in the first embodiment.

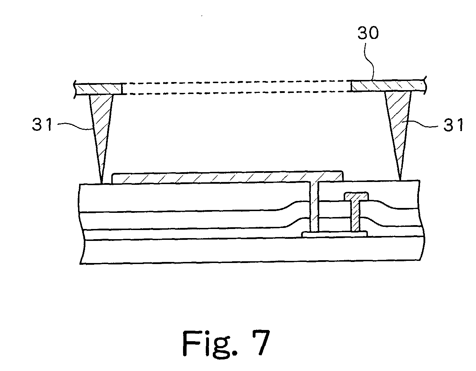

A manufacturing method of an EL display using the mask according to the second embodiment will now be described. As shown in Fig. 7, in a vacuum chamber, a mask 30 is placed in proximity to a glass substrate 10 which is a base structure onto which a TFT and a first electrode (ITO) of the EL element are formed. Because of the flexure of the glass substrate 10, the glass substrate 10 locally contacts the projections 31 on the mask 30. The opening of the mask 30 is aligned with the desired emissive region on the glass substrate 10. The projections 31 are then in contact with the non-emissive region on the glass substrate 10.

After the position is aligned, a gap of a predetermined distance is maintained by the projections 31 while deposition materials are sequentially evaporated from depositing material sources (not shown) through the opening of the mask 30, to sequentially evaporate and laminate, for example, a hole transport layer HTL, an emissive layer LEL, and an electron transport layer ETL. The mask 30 is then removed, a cathode is formed, and the EL display is sealed.

When an EL display is manufactured using the mask 30 according to the second embodiment, the local contact of the mask 30 with the display region of the glass substrate 10 can be prevented by the projections 31. As a result the possibility of damage to the TFT, hole transport layer, or the like, and probability of dark spots are both reduced.

## Claims

1. An electroluminescence display comprising:
an emissive element layer including an emissive layer and formed between a first electrode and a second electrode by placing, in contact with a base structure onto which said first electrode is formed, a mask having an opening for allowing an emissive material to be deposited onto a desired emissive region, and depositing said emissive material from an emissive material source through said opening, wherein,
at least one of said base structure and said mask comprises projections for maintaining a predetermined distance between said base structure and said mask, and said projections being in contact with the non-emissive regions on said base structure.

2. A method for manufacturing an electroluminescence display wherein
when an emissive layer is formed between a first electrode and a second electrode by placing, in contact with a base structure onto which said first electrode is formed, a mask having an opening for allowing an emissive material to be deposited onto a desired emissive region, and depositing the emissive material from an emissive material source through said opening,
projections for maintaining a predetermined distance between said base structure and said mask are provided on a non-emissive region of said base structure, and the emissive material is deposited onto the desired emissive region on said base structure while the distance between said base structure and said mask is maintained.

3. An electroluminescence display or a method for manufacturing an electroluminescence display according to either claim 1 or 2, wherein said projections are provided corresponding to each pixel.

4. An electroluminescence display or a method for manufacturing an electroluminescence display according to either claim 1 or 2, wherein said projections are provided between pixels.

5. An electroluminescence display or a method for manufacturing an electroluminescence display according to any one of claims 1 through 4, wherein, when a plurality of display panels are formed on said base structure using gang printing, said projections are provided between said display panels.

6. An electroluminescence display which is manufactured by a method for manufacturing an electroluminescence display according to any one of claims 2 through 5.

7. A mask for placement between an emissive material source and a base structure which is the deposition target of the emissive material, said mask having:
an opening for allowing said emissive material to be deposited onto a desired emissive region on said base structure, and
projections for maintaining a predetermined distance from said base structure.
